Europäisches Patentamt

European Patent Office

Office européen des brevets

(11) Veröffentlichungsnummer: **0 338 190**

**A2**

# (12) EUROPÄISCHE PATENTANMELDUNG

(21) Anmeldenummer: 89101062.1

(22) Anmeldetag: 21.01.89

(51) Int. Cl.4: **H01L 21/90 , H01L 23/52**

(30) Priorität: 15.04.88 DE 3812494

(43) Veröffentlichungstag der Anmeldung:
25.10.89 Patentblatt 89/43

(84) Benannte Vertragsstaaten:
FR GB IT NL

(71) Anmelder: **ANT Nachrichtentechnik GmbH**
**Gerberstrasse 33**
**D-7150 Backnang(DE)**

(72) Erfinder: **Schlichenmaier, Dieter, Dr. rer. nat.**
**Neuffenstrasse 4**
**D-7153 Weissach im Tal(DE)**

(54) **Verfahren zur Herstellung von luftisolierten Überkreuzungen und nach diesem Verfahren hergestellte luftisolierte Überkreuzung.**

(57) Da die Tendenz in der integrierten Schaltungstechnik zu immer feineren Strukturen geht, ist es nötig, die Überkreuzungen an diese miniaturisierten Schaltungen anzupassen. Außerdem sollen die luftisolierten Überkreuzungen mechanisch stabil sein.

Es wird ein Herstellungsverfahren und eine isolierte Überkreuzung angegeben, die zur Erzeugung von feinen Strukturen geeignet sind. Ein Keramiksubstrat mit Leiterbahnen wird mit Kupfer beschichtet, in das über den Kontaktstellen auf den Leiterbahnen Löcher geätzt werden. Die Kontaktstellen und das dazwischen liegende Kupfer werden galvanisch mit Gold verstärkt. So entsteht mittels eines Maskenverfahrens mit zweifacher Belichtung die Überkreuzung. Durch das Abätzen des Kupfers bleibt Luft als Dielektrikum erhalten.

Lange-Koppler, feinere Strukturen für planare Schaltungen.

EP 0 338 190 A2

# Verfahren zur Herstellung von luftisolierten Überkreuzungen und nach diesem Verfahren hergestellte luftisolierte Überkreuzung

Die Erfindung betrifft ein Verfahren zur Herstellung von luftisolierten Überkreuzungen nach dem Oberbegriff des Anspruches 1 und eine nach diesem Verfahren hergestellte luftisolierte Überkreuzung nach dem Oberbegriff des Anspruches 6.

Da die Tendenz zu immer feineren Strukturen geht, was zum Beispiel durch immer höhere Frequenzen bedingt ist, wird das Bondverfahren durch andere Verfahren, die für feinere Strukturen geeignet sind, ersetzt. Dabei ist zu beachten, daß die Überkreuzungen mit hoher Genauigkeit an den vorgesehenen Stellen aufgebracht werden müssen und daß die Überkreuzungen auch ohne Stütze stabil sein müssen.

In einem Aufsatz von M. Cichetti "Thin-Film Technology" nach einem Vortrag auf dem Seminar "Microelectronics in system design" in Mailand vom 7. bis 9. Mai 1973, wird die Herstellung einer luftisolierten Überkreuzung beschrieben. Als Ausgangsstoff wird ein mit Ni-Cr und Gold beschichtetes Keramiksubstrat mit Leiterbahnen aus Gold angegeben, das galvanisch mit Kupfer beschichtet wird. Mittels eines Masken-Verfahrens werden Löcher in die Kupferschicht geätzt, an den Stellen, an denen Kontaktstellen vorgesehen sind. Die Kontaktstellen und das dazwischen liegende Kupfer werden mit einer Goldschicht überzogen und das Kupfer anschließend abgeätzt, wodurch die luftisolierte Überkreuzung entsteht.

Auch aus der US-PS 4,601,915 ist ein Verfahren zur Herstellung von luftisolierten Überkreuzungen bekannt, bei dem im Bereich der vorgesehenen Überkreuzungen ein in einem späteren Verfahrensschritt zu entfernende Kupferschicht vorgesehen ist und bei dem im Bereich der Kontaktstellen kein Kupfer vorhanden ist. Die Durchführung des Verfahrens erfordert jedoch die Verwendung mehrerer Fotomaskenschichten.

Aus der US-PS 4,436,766 und der US-PS 4,670,297 sind Verfahren zum Herstellen einer luftisolierten Anschlußbrücke bzw. einer Überkreuzung bekannt, bei denen die erste, zur Definition der Kontaktstellen verwendete Fotomaskenschicht bis nach dem Herstellen der Brücke bzw. Überkreuzung vorhanden bleibt. Zur Strukturierung der Brücke bzw. der Überkreuzung sind jedoch jeweils eine weitere Fotomaskenschicht notwendig.

Bei dem aus der US-PS 4,670,297 bekannten Verfahren wird das Metall der Überkreuzung durch Maskenöffnungen aufgedampft.

Es ist Aufgabe der Erfindung, ein Verfahren zur Herstellung von luftisolierten Überkreuzungen und eine nach diesem Verfahren hergestellte luftisolierte Überkreuzung anzugeben, das bzw. die an die Anforderungen von miniaturisierten Schaltungen angepaßt ist und die eine hohe mechanische Stabilität aufweist.

Die Aufgabe wird gelöst durch ein Verfahren mit den Merkmalen des Patentanspruches 1 und durch eine luftisolierte Überkreuzung mit den Merkmalen des Patentanspruches 6.

Vorteilhafte Weiterbildungen bezüglich des Verfahrens sind in den Unteransprüchen beschrieben.

Eine luftisolierte Überkreuzung weist den Vorteil auf, daß keine Nadellochkurzschlüsse zwischen der Überkreuzung und dem überbrückten Leiter entstehen können. Außerdem ist die kapazitive Kopplung gering, da als Dielektrikum Luft vorliegt. Mit dem erfindungsgemäßen Verfahren bzw. der erfindungsgemäßen luftisolierten Überkreuzung ist eine Verbindung von Leiterbahnen mit geringer Induktivität möglich, da eine breite Verbindung in der Größenordnung von 30 - 100 $\mu$m auf kurzem Weg in der Größenordnung von 100 m möglich ist. Strukturen in der Größenordnung von 20 - 30 $\mu$m können hergestellt werden. Es ist an sich bekannt, daß feine Strukturen auf einer Haftschicht aus TiW möglich sind. In dem Aufsatz "Thin-Film Technology" wird jedoch Ni-Cr als Haftschicht verwendet, mit der keine solchen feinen Leiterbahnstrukturen möglich sind, da die Leiterbahnen stark unterätzt werden.

Das Maskenverfahren, das angewendet wird, um Löcher in die Kupferschicht zu ätzen, wird in dem Aufsatz nicht näher beschrieben. Außerdem schließt sich an das Ätzen der Löcher direkt das Beschichten mit Gold an. Es ist aus dem Aufsatz nicht ersichtlich, wie diese Verfahrensschritte ablaufen. Nach dem erfindungsgemäßen Verfahren wird ein Maskenverfahren mit zweifacher Belichtung durchgeführt, wobei die zweite Belichtung nach dem Ätzen der Löcher in die Kupferschicht stattfindet und dazu dient, den Fotolack zwischen den Löchern durch Entwickeln zu entfernen. Danach werden die metallischen Flächen galvanisch mit Gold verstärkt. Durch die Anwendung dieser erfindungsgemäßen Verfahrensschritte entsteht eine luftisolierte Überkreuzung mit den erfindungsgemäßen Merkmalen, die zu einer hohen mechanischen Stabilität führen.

Eine erfindungsgemäße luftisolierte Überkreuzung ist mechanisch sehr stabil aufgrund der halbschalenförmigen Kontaktierungen. Untersuchungen haben gezeigt, daß die Stabilität höher ist als die einer Bondverbindung.

Ausführungsbeispiele werden anhand der Zeichnungen erläutert. Es zeigen

Fig. 1a - 1g: ein Substrat, auf das Leiter und eine Überkreuzung aufgebracht werden, nach den verschiedenen Herstellungsschritten;

Figur 2: eine luftisolierte Überkreuzung.

Figur 1a zeigt ein Keramiksubstrat 10, beispielsweise ein Substrat aus $Al_2O_3$. Dieses weist eine Schicht 12 aus TiW und Gold auf. Die Beschichtung kann in einer Sputteranlage erfolgen, die Dicke der Goldauflage kann zwischen 0,2 und 0,5 μm betragen. Das bedampfte Substrat 10,12 wird mit einem Fotolack 11 beschichtet, der dann belichtet und entwickelt wird und so die gewünschte Leiterbahnenstruktur auf dem bedampften Substrat 10,12 freigibt.

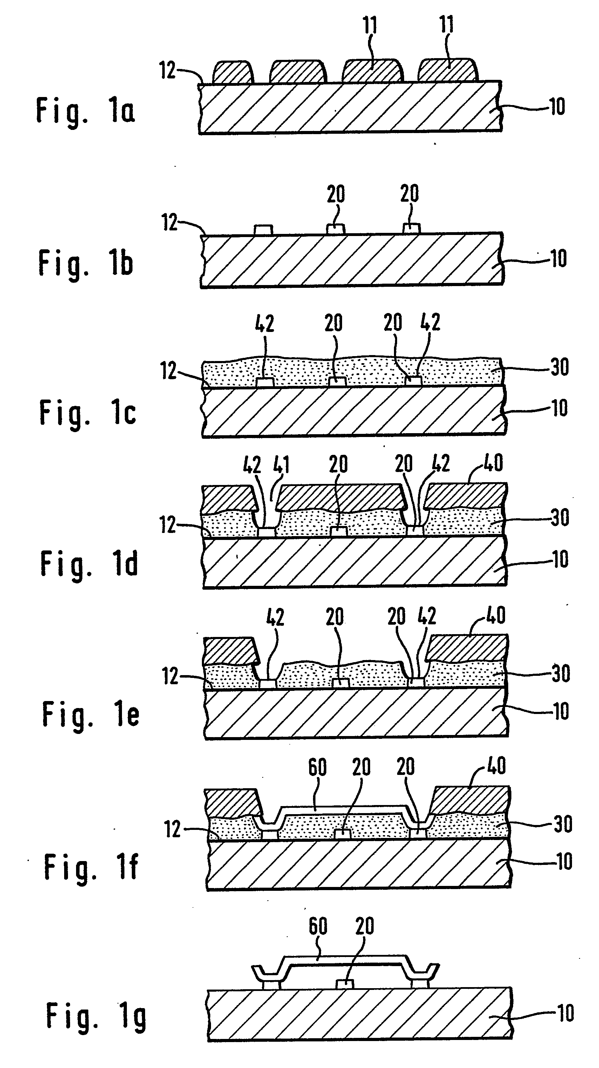

Figur 1b zeigt die Leiterbahnen 20, die in einem Goldbad aufgalvanisiert wurden. Der Fotolack wurde entfernt. Die Dicke der Leiterbahnen 20 beträgt beispielsweise 2-5 m. Die Leiterbahnen 20 sind also wesentlich dicker als die darunter liegende Goldschicht 12. In einem weiteren Verfahrensschritt wird eine Kupferschicht 30 auf das bedampfte Substrat 10,12 und die Leiterbahnen 20 aufgetragen. Dies kann ebenfalls galvanisch erfolgen. Das Produkt nach diesem Verfahrensschritt ist in Figur 1c dargestellt. Die Dicke der Kupferschicht 30 wird in Abhängigkeit von der Größe der Kontaktfläche 42 der Überkreuzung 60 auf der Leiterbahn 20 gewählt. Ist die Kontaktfläche beispielsweise 20 μm x 20 μm groß, dann sollte die Kupferschichtdicke ungefähr 15 μm betragen. Auf die Kupferschicht 30 wird ein positiv arbeitender Fotolack 40 aufgetragen und an den Stellen, die über Kontaktstellen 42 liegen, belichtet. Durch das sich anschließende Entwickeln des Fotolackes 40 werden die belichteten Teile des Lackes entfernt.

Wie in Figur 1d dargestellt, werden mittels eines Ätzvorganges Löcher 41 in die Kupferschicht 30 geätzt. Die Lackmaske wird dabei isotrop unterätzt. Die Leiterbahnen 20 werden an den Kontaktstellen 42 freigelegt. Dann wird der Fotolack 40 ein zweites Mal belichtet und entwickelt derart, daß die Verbindung zwischen den Löchern 41 vom Fotolack befreit wird. Dieser Zustand ist in Figur 1e wiedergegeben. Die freigelegten und die geätzten Schichten aus Kupfer und die Kontaktstellen 42 werden dann mit Gold galvanisch verstärkt (Figur 1f).

Die Überkreuzung 60 entsteht. Wenn man nun den Fotolack 40 strippt, die Kupferschicht 30 abätzt und die dünne Goldschicht 12 und die Haftschicht 12 aus TiW naßchemisch abätzt, so erhält man eine luftisolierte Überkreuzung 60, wie sie in Figur 1g im Schnitt dargestellt ist.

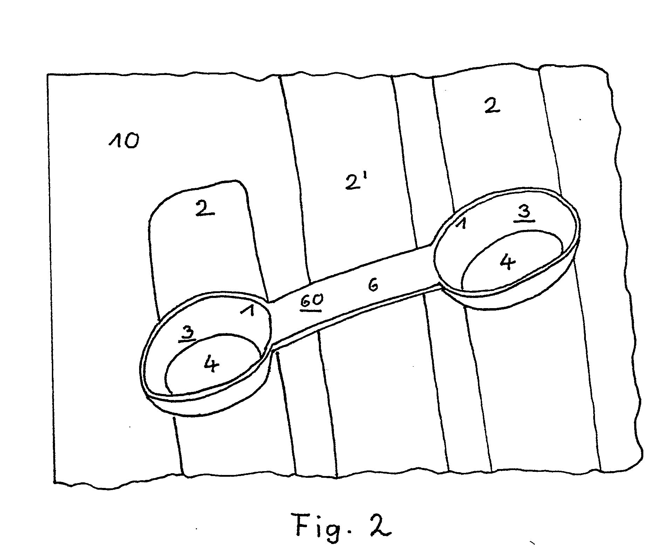

Eine perspektivische Darstellung einer nach dem erfindungsgemäßen Verfahren hergestellten luftisolierten Überkreuzung 60 zeigt Figur 2. Auf einem Substrat 10 sind drei parallele Leiterbahnen 2,2' angebracht, von denen die beiden äußeren durch eine Überkreuzung 60 miteinander verbunden sind. Die Überkreuzung 60 weist zwei halbschalenförmige nach oben geöffnete Kontaktierungen 3 auf, die an ihrem oberen Schalenrand 1 durch einen Steg 6 miteinander verbunden sind. Je eine Kontaktierung 3 sitzt mit dem Schalenboden 4 auf einer der äußeren Leiterbahnen 2. Durch die halbschalenförmige Struktur der Kontaktierungen erweisen sich diese als besonders stabil. Die Haftfestigkeit kann durch einen nachfolgenden Diffusionsprozeß erhöht werden.

Das erfindungsgemäße Verfahren bzw. eine nach dem erfindungsgemäßen Verfahren hergestellte luftisolierte Überkreuzung ist dazu geeignet, feine Strukturen bei planaren Schaltungen herzustellen, Bondverbindungen zu ersetzen und integrierte Überkreuzungen Z.B. für Lange-Koppler herzustellen.

**Ansprüche**

1. Verfahren zur Herstellung von luftisolierten Überkreuzungen mit den folgenden Merkmalen:
a) Auf einem Keramiksubstrat (10) mit einer Edelmetallschicht (12), welche Leiterbahnen (20) aus Edelmetall aufweist, die wesentlich dicker als die Edelmetallschicht (12) sind und auf denen Kontaktstellen (42) für Überkreuzungen vorgesehen sind, wird großflächig eine Kupferschicht (30) aufgetragen (Fig. 1c).
b) Auf diese Kupferschicht (30) wird ein positiv arbeitender Fotolack (40) großflächig aufgetragen und derart belichtet, daß die Kupferschicht (30) beim Entwickeln des Fotolackes (40) nur über den vorgesehenen Kontaktstellen (42) für die Überkreuzungen freigelegt wird.
c) Über den Kontaktstellen werden Löcher (41) in die Kupferschicht (30) geätzt (Fig. 1d).
d) Dann wird der Fotolack (40) zwischen den Löchern (41) an den Stellen, an denen die Überkreuzung entstehen soll, belichtet und entwickelt (Fig. 1e).
e) Alle metallischen Flächen werden galvanisch mit Edelmetall beschichtet, so daß zwischen den zu verbindenden Kontaktstellen (42) die Überkreuzungen (60) entstehen (Fig. 1f).
f) Der Fotolack (40) wird entfernt.
g) Das Kupfer der Kupferschicht (30), einschließlich des Kupfers unter den Überkreuzungen (60), wird abgeätzt.
h) Die Edelmetallschicht (12) wird abgeätzt.
Die Merkmale a), c), g) bilden den Oberbegriff, die restlichen Merkmale den kennzeichnenden Teil.

2. Verfahren nach Anspruch 1, dadurch gekennzeichnet, daß als Haftschicht zwischen Keramiksubstrat (10) und Edelmetallschicht (12) eine Schicht aus Titan-Wolfram aufgebracht wird.

3. Verfahren nach Anspruch 2, dadurch gekennzeichnet, daß die Edelmetallschicht (12) und die Schicht aus Titan-Wolfram nach dem Abätzen der Kupferschicht (30) abgeätzt werden.

4. Verfahren nach einem der Ansprüche 1 bis 3, dadurch gekennzeichnet, daß als Edelmetall Gold für die Beschichtung (12), die Leiterbahnen (20) und die Überkreuzung (60) eingesetzt wird.

5. Verfahren nach einem der Ansprüche 1 bis 4, dadurch gekennzeichnet, daß die Dicke der Kupferschicht von der gleichen Größenordnung wie die Länge oder Breite der Kontaktstelle ist.

6. Luftisolierte Überkreuzung, hergestellt mit dem Verfahren nach einem der Ansprüche 1 bis 5, die einen Zwischenleiter (2') durch eine stegartige Verbindung (6) überbrückt und zwei unterschiedliche Leiter (2) miteinander verbindet, dadurch gekennzeichnet, daß sie halbschalenförmige Kontaktierungen (3) aufweist, die jeweils am Schalenrand (1) die stegartige Verbindung (6) aufweisen und am Schalenboden (4) mit jeweils einem der Leiter (2) verbunden sind.

Fig. 1a

Fig. 1b

Fig. 1c

Fig. 1d

Fig. 1e

Fig. 1f

Fig. 1g

Fig. 2